# EUROPÄISCHE PATENTSCHRIFT

(11) **EP 0 925 383 B1**
(45) Veröffentlichungstag und Bekanntmachung des Hinweises auf die Patenterteilung: **30.05.2001**
(21) Anmeldenummer: 97940144.5
(22) Anmeldetag: 29.08.1997
(51) Int. Cl.: C23C 16/30, C23C 16/00

(54) **VERFAHREN ZUR BESCHICHTUNG VON SUBSTRATEN DURCH CVD MIT EINER SILIZIUMHALTIGEN SCHUTZSCHICHT**
PROCESS FOR COATING SUBSTRATES WITH A SILICIUM-CONTAINING PROTECTIVE LAYER BY CHEMICAL VAPOUR DEPOSITION
PROCEDE POUR L'ENDUCTION DE SUBSTRATS PAR DEPOT CHIMIQUE EN PHASE VAPEUR AVEC UNE COUCHE DE PROTECTION CONTENANT DU SILICIUM

(30) Priorität: 04.09.1996 DE 19635848
(43) Veröffentlichungstag der Anmeldung: 30.06.1999
(73) Patentinhaber: BAYER AG, 51368 Leverkusen (DE)
(72) Erfinder: BALDUS, Hans-Peter, D-51379 Leverkusen (DE); PASSING, Gerd, D-50668 Köln (DE); SCHÖNFELDER, Lothar, D-96450 Coburg (DE); MEISTRING, Rolf, D-85625 Glonn (DE); BENIEN, Hannelore, D-81739 München (DE); HALTRICH, Marc, D-83043 Kolbermoor (DE)
(86) Internationale Anmeldenummer: EP9704715
(87) Internationale Veröffentlichungsnummer: WO9810118

(56) Entgegenhaltungen:
- EP-A- 0 355 366
- DE-C- 1 963 584
- GB-A- 792 274

## Beschreibung

Die Erfindung bezieht sich auf ein Verfahren zur Beschichtung von Substraten durch chemische Dampfbeschichtung (CVD) mit einer siliziumhaltigen Schutzschicht.

Um Hochtemperatur-Bauteile aus Kohlenstoff vor Oxidation zu schützen, ist es bekannt, das Bauteil durch CVD unter Verwendung von Silanen mit einer Quarzglas (SiO₂)-Schicht zu versehen. Bei einer Temperatur oberhalb etwa 1.100°C geht die amorphe Quarzglasschicht in den kristallinen Zustand (Cristobalit) über. Dieser sogenannte Quarzsprung führt zu Rissen in der Beschichtung, die insbesondere nach Abkühlung und erneuter Erwärmung des Bauteils, also bei Temperaturwechselbeanspruchung, zu einer raschen Oxidation des Kohlenstoffbauteils führen.

Zwar kann die Rißbildung durch weitere Schichten, beispielsweise Siliziumcarbid-Schichten zurückgedrängt werden, jedoch ist das Aufbringen einer solchen Folge unterschiedlicher Schichten mit entsprechend viel Prozeßschritten verbunden und damit kosten- und zeitaufwendig. Zudem führt eine durch CVD auf ein Metallsubstrat aufgebrachte Quarzglasschicht bei mechanischer Beanspruchung sowie Temperaturwechselbeanspruchung zu Abplatzungen.

Aufgabe der Erfindung ist es, Substrate unterschiedlicher Art auf einfache Weise mit einer festhaftenden Schutzschicht zu versehen, die auch hohen Temperaturwechselbeanspruchungen standhält.

Dies wird erfindungsgemäß durch das im Anspruch 1 gekennzeichnete Verfahren erreicht. In den Unteransprüchen sind vorteilhafte Ausgestaltungen der Erfindung wiedergegeben. Die beschichteten Substrate, die nach dem erfindungsgemäßen Verfahren erhältlich sind, sind in Anspruch 9 beansprucht.

Nach der Erfindung wird als Ausgangsverbindung für das CVD-Verfahren zur Beschichtung des Substrats eine Verbindung folgender Struktur (1) eingesetzt: 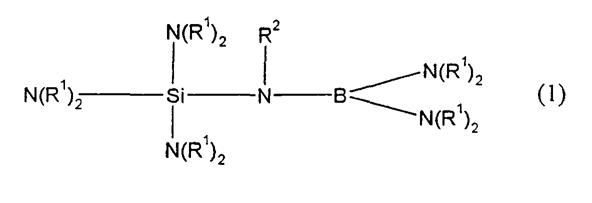 worin
- R¹: eine Alkylgruppe mit 1 bis 4 Kohlenstoffatomen und
- R²: Wasserstoff oder eine Alkylgruppe mit 1 bis 4 Kohlenstoffatomen ist.

Vorzugsweise ist R¹ ein Methylrest und R² Wasserstoff. Das heißt, es wird vorzugsweise Tri(dimethylaminosilyl)-amino-di(dimethylamino)boran eingesetzt, das folgende Strukturformel (2) besitzt:

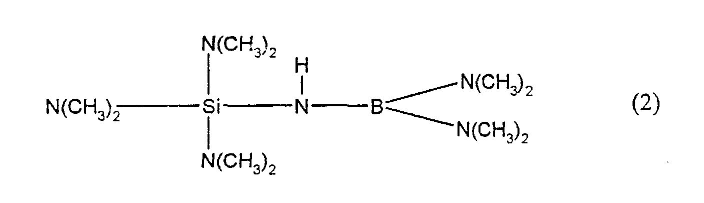

Als CVD-Verfahren wird vorzugsweise ein thermisches CVD-Verfahren angewendet, insbesondere ein LPCVD (low pressure CVD)-Verfahren. Statt dem thermischen CVD-Verfahren können erfindungsgemäß jedoch auch andere CVD-Verfahren eingesetzt werden, insbesondere Plasma-CVD.

Die Vorrichtung für das thermische CVD-Verfahren weist vorzugsweise einen druckdichten Vorratsbehälter auf, der die flüssige Ausgangsverbindung gemäß der Formel (1) bzw. (2) enthält und durch ein Inertgas, z.B. Argon, unter Druck steht. Die flüssige Ausgangsverbindung wird über ein Durchflußmeßgerät einer Mischeinrichtung zugeführt, in die zugleich über ein entsprechendes Gasdurchflußmeßgerät ein Inertgas, beispielsweise Stickstoff, strömt, wodurch in der Mischeinrichtung aus der flüssigen Ausgangsverbindung ein Aerosol gebildet wird, das in einem erwärmten Verdampfer rückstandsfrei verdampft wird. Der Dampf wird dem einen Ende eines vorzugsweise rohrförmig ausgebildeten Beschichtungsofens zugeführt, in den das zu beschichtende Substrat oder mehrere Substrate über- und/oder hintereinander angeordnet sind. An das andere Ende des rohrförmigen Ofens ist eine Vakuumpumpe angeschlossen.

Wenn als Ausgangsverbindung Tri(dimethylaminosilyl)-amino-di(dimethylamino)-boran eingesetzt wird, beträgt die Temperatur des Verdampfers beispielsweise 40°C bis 150°C, vorzugsweise 75°C bis 100°C. Der Unterdruck im Beschichtungsofen kann 10⁻¹ bis 10⁻⁵ bar betragen; normalerweise liegt er bei 10⁻² bis 10⁻³ bar.

Mit der beschriebenen CVD-Vorrichtung können die Abscheidungsbedingungen genau eingehalten und damit Schichten mit sehr reproduzierbaren Eigenschaften erhalten werden.

In dem Beschichtungsofen wird das Substrat auf eine Temperatur von 400°C bis 1800°C, insbesondere 650°C bis 1400°C erwärmt. Damit läßt sich eine bis 1900°C amorph bleibende Schicht herstellen.

Die nach dem erfindungsgemäßen Verfahren hergestellte Schicht enthält die Elemente (wobei dieser Begriff auch Bindungen untereinander einschließt): Silizium, Stickstoff, Bor und Kohlenstoff. Die Elemente: Si, N und B können, wie in der Ausgangsverbindung, im Molverhältnis 1:1:1 vorliegen. Neben den Elementen Si, N, B und C kann die Schicht organische Reste, welche aus der Ausgangsverbindung gebildet sind, enthalten, die die Eigenschaften der Schicht beeinflussen. Wenn diese organischen Reste aus der Schicht entfernt werden sollen, wird das Substrat auf eine entsprechend hohe Temperatur erwärmt. Die CVD-Abscheidung in dem Ofen kann jedoch auch bei einer eher niedrigeren Temperatur des Substrats erfolgen und eine thermische Nachbehandlung bei 600°C bis 1800°C in einem Ofen vorgenommen werden, um die organischen Reste auszutreiben.

Die so gebildete Si-N-B-C-Schicht ist insbesondere zum Schutz von Metallteilen geeignet. Die Metallteile können beispielsweise aus Stahl oder einer Titanlegierung bestehen.

Die nach dem erfindungsgemäßen Verfahren auf das Metallteil aufgebrachte Schutzschicht zeichnet sich durch eine hohe Haftfestigkeit aus. Diese fällt insbesondere dann extrem gut aus, wenn das Metallteil im unpolierten Zustand beschichtet wird, also eine Rauhtiefe von mehr als 5 µm besitzt.

Die durch das erfindungsgemäße Verfahren auf dem Metallteil aufgebrachte Schicht weist neben der hohen Haftfestigkeit eine hohe Verschleißfestigkeit und Schmiereigenschaften auf. Letztere können durch den Anteil der organischen Reste, die von den Alkylgruppen des Ausgangssubstrats herrühren, beeinflußt werden.

Aufgrund der hervorragenden tribologischen Eigenschaften der erfindungsgemäß erzeugten keramischen Schutzschicht kann das erfindungsgemäße Verfahren beispielsweise zur Beschichtung von Metallteilen im Motorenbau eingesetzt werden.

Neben der Beschichtung von Metall-Substraten ist das erfindungsgemäße Verfahren vor allem auch zum Beschichten von Kohlenstoff-Substraten oder von Composit-Substraten aus Kohlenstoff und Silizium hervorragend geeignet, die einer hohen Temperatur ausgesetzt sind, insbesondere einer hohen Temperaturwechselbeanspruchung, beispielsweise in der Raumfahrt, z.B. für die Düsen von Strahltriebwerken. Darüber hinaus ist es zum Beschichten von Keramik-Substraten geeignet.

Wenn die nach dem erfindungsgemäßen Verfahren mit der Si-N-B-C-Schutzschicht beschichteten Bauteile aus Kohlenstoff, siliziertem Kohlenstoff bzw. Keramik auf Temperaturen von beispielsweise 900°C bis 1800°C, insbesondere 1200°C bis 1600°C in einer sauerstoffhaltigen Atmosphäre, also z.B. an der Luft, erhitzt werden, wird das Si an der Oberfläche der Schutzschicht zu SiOₓ, d.h. SiO und SiO₂, oxidiert.

Diese Oxidation kann durch Nachbehandlung des beschichteten Substrats in einem Ofen erfolgen, oder beim Einsatz des Bauteils an der Luft bei hohen Temperatauren.

Das an der Oberfläche des Bauteils gebildete SiOₓ weist durch das Bor einen relativ niedrigen Schmelzpunkt auf. Dies hat zur Folge, daß die Schutzschicht im Oberflächenbereich schon bei relativ niedriger Temperatur schmilzt und die Schmelze etwaige entstehende Risse in dem darunterliegenden Bereich der Schutzschicht verschließt, wodurch das Eindringen von Sauerstoff zu dem Kohlenstoff bzw. Kohlenstoff/Silizium-Substrat verhindert wird. Das heißt, der SiOₓ-Gehalt in der Oberfläche der Schutzschicht wirkt bei hohen Temperaturen, während die Si-N-B-C-Phase der übrigen Schutzschicht, also die Grundschicht bei niedrigen Temperaturen das Bauteil vor Oxidation schützt. Gleiches gilt für die stickstoffhaltigen Substrate.

Durch das erfindungsgemäße Verfahren wird eine Schutzschicht erzeugt, die nach den bisherigen Verfahren das beschichtete Bauteil auch bei Temperaturwechselbelastung bis etwa 1900°C sicher vor Oxidation schützt.

Die nachfolgenden Beispiele dienen der Erläuterung des erfindungsgemäßen Verfahrens, ohne dabei limitierend zu wirken.

### Ausführungsbeispiele

### Beispiel 1

Zwei Substrate aus reaktionsgebundenem Si₃N₄ wurden im Beschichtungsofen auf 900°C erhitzt. 2 ml der Ausgangsverbindung Tri(dimethylaminosilyl)-amino-di(dimethylamino)boran wurden bei 90°C verdampft und durch den Beschichtungsofen geleitet. Der Druck im Ofen betrug 5 x 10⁻⁵ bar. Nach 90 Minuten war die Ausgangsverbindung aufgebraucht und die Substrate wurden auf Raumtemperatur abgekühlt. Eines der zwei Substrate wurde bei gleichen Bedingungen nochmals beschichtet. Anschließend wurden die Substrate 1 Stunde lang bei 1450°C in Stickstoff ausgelagert. Die Beschichtungen bedeckten die Substrate gleichmäßig. Röntgenelektronenmikroskopische (REM) und transmissionselektronenmikroskopische (TEM) Aufnahmen zeigten den innigen Verbund zwischen dem Substrat und der ersten Beschichtung sowie zwischen erster und zweiter Beschichtung. Beide aufgebrachten Schichten waren amorph. Elektronendispersive Röntgen (EDX)-Analysen ergaben, daß die Schicht Si, N, B und C enthielt. Die Schichtdicke wurde an der zweifach beschichteten Probe gemessen, sie betrug insgesamt 7 bis 8 µm.

### Beispiel 2

Substrate aus reaktionsgebundenem Si₃N₄ wurden im Beschichtungsofen auf 950°C erhitzt. 4 ml der Ausgangsverbindung Tri(dimethylaminosilyl)-amino-di(dimethylamino)boran wurden bei 80°C verdampft und in den Beschichtungsofen geleitet. Der Druck im Ofen betrug 2 x 10⁻⁵ bar. Nachdem die Ausgangsverbindung verdampft war, wurden die Substrate auf Rautmemperatur abgekühlt. Die Substrate wurden bei gleichen Bedingungen ein zweites Mal beschichtet. Anschließend erfolgte eine zweistündige Auslagerung der Substrate in Stickstoff bei 1450°C. Die Beschichtungen bedeckten die Substrate gleichmäßig.

### Beispiel 3

Ein Substrat aus Graphit wurde im Beschichtungsofen auf 1000°C erhitzt. 1 ml der Ausgangsverbindung Tri(dimethylaminosilyl)-amino-di(dimethylamino)boran wurde bei 100°C verdampft und durch den Beschichtungsofen geleitet. Der Druck im Ofen betrug 2,7 x 10⁻³ bar. Nachdem die Ausgangsverbindung verdampft war, erfolgte die Abkühlung des Substrates auf Raumtemperatur. Anschließend fand eine einstündige Auslagerung der Substrate in Stickstoff bei 1450°C statt. Die Beschichtung bedeckte das Substrat gleichmäßig. Röntgenelektronenmikroskopische (REM) Untersuchungen zeigten einen innigen Verbund zwischen dem Substrat und der Beschichtung. Messungen mit der Röntgen-Mikroanalyse zeigten Si, B, N und C in der Schicht. Die Schichtdicke betrug 2,6 µm.

## Patentansprüche

1. Verfahren zur Beschichtung von Substraten durch chemische Dampfbeschichtung (CVD) mit einer siliziumhaltigen Schutzschicht, dadurch gekennzeichnet, daß zur chemischen Dampfbeschichtung eine Ausgangsverbindung folgender Strukturformel eingesetzt wird: 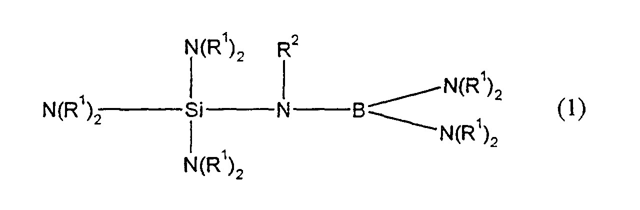 worin
R¹ eine Alkylgruppe mit 1 bis 4 Kohlenstoffatomen und
R² Wasserstoff oder eine Alkylgruppe mit 1 bis 4 Kohlenstoffatomen ist.

2. Verfahren nach Anspruch 1, dadurch gekennzeichnet, daß als Ausgangsverbindung Tri(dimethylaminosilyl)-amino-di(dimethylamino)boran eingesetzt wird.

3. Verfahren nach Anspruch 1 oder 2, dadurch gekennzeichnet, daß die chemische Dampfbeschichtung durch thermische Dampfbeschichtung bei niedrigem Druck (LPCVD) erfolgt.

4. Verfahren nach Anspruch 3, dadurch gekennzeichnet, daß der Druck 10⁻¹ bis 10⁻⁵ bar beträgt.

5. Verfahren nach einem der vorstehenden Ansprüche, dadurch gekennzeichnet, daß das Substrat während der Beschichtung auf eine Temperatur von 400°C bis 1800°C erwärmt wird.

6. Verfahren nach einem der vorstehenden Ansprüche, dadurch gekennzeichnet, daß das Substrat nach der Beschichtung einer thermischen Nachbehandlung bei 600°C bis 1800°C unterworfen wird.

7. Verfahren nach Anspruch 6, dadurch gekennzeichnet, daß das Substrat bei der Nachbehandlung einer sauerstoffhaltigen Atmosphäre ausgesetzt wird.

8. Verfahren nach einem der vorstehenden Ansprüche, dadurch gekennzeichnet, das als Substrat ein Metall- oder ein Kohlenstoff-Substrat oder ein Substrat aus Kohlenstoff und Silizium oder ein Substrat aus Kohlenstoff, Stickstoff und Silizium oder Stickstoff und Silicium eingesetzt wird.

9. Beschichtete Substrate, erhältlich nach einem Verfahren gemäß einem oder mehreren der vorangegangenen Ansprüche 1 bis 8.

## Claims

1. Process for coating substrates with a protective silicon-containing layer by chemical vapour deposition (CVD), characterized in that a starting compound used for the chemical vapour deposition has the following structural formulae: 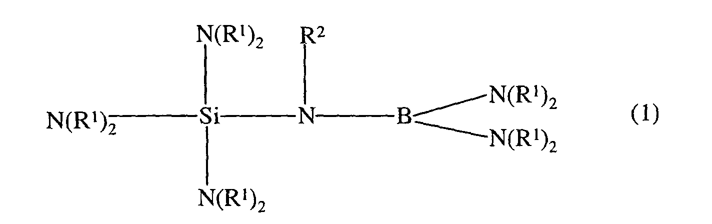 in which
R¹ is an alkyl group having 1 to 4 carbon atoms, and
R² is hydrogen or an alkyl group having 1 to 4 carbon atoms.

2. Process according to Claim 1, characterized in that the starting compound used is tri(dimethylaminosilyl)-amino-di(dimethylamino)borane.

3. Process according to Claim 1 or 2, characterized in that the chemical vapour deposition is carried out by low-pressure chemical vapour deposition (LPCVD).

4. Process according to Claim 3, characterized in that the pressure is from 10⁻¹ to 10⁻⁵ bar.

5. Process according to any of the preceding claims, characterized in that the substrate is heated at a temperature of from 400°C to 1800°C during the coating.

6. Process according to any of the preceding claims, characterized in that after the coating the substrate is subjected to a further heat treatment at from 600°C to 1800°C.

7. Process according to Claim 6, characterized in that during the further treatment the substrate is exposed to an oxygen-containing atmosphere.

8. Process according to any of the preceding claims, characterized in that the substrate used is a metal substrate or a carbon substrate or a substrate comprising carbon and silicon or a substrate comprising carbon, nitrogen and silicon or nitrogen and silicon.

9. Coated substrates obtainable using a process according to one or more of the preceding Claims 1 to 8.

## Revendications

1. Procédé pour appliquer sur des substrats une couche protectrice contenant du silicium par déposition chimique en phase vapeur (CVD) caractérisé en ce que, pour la déposition chimique en phase vapeur, on utilise un composé de départ possédant la formule de structure suivante : 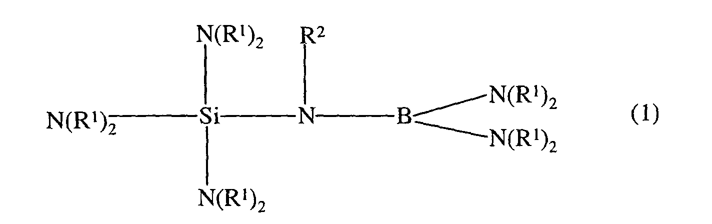 dans laquelle
R¹ représente un groupe alkyle en C₁-C₄ et
R² représente l'hydrogène ou un groupe alkyle en C₁-C₄.

2. Procédé selon la revendication 1, caractérisé en ce que le composé de départ est le tri(diméthylaminosilyl)-amino-di(diméthylamino)borane.

3. Procédé selon la revendication 1 ou 2, caractérisé en ce que la déposition chimique en phase vapeur est une déposition thermique en phase vapeur à basse pression (LPCVD).

4. Procédé selon la revendication 3, caractérisé en ce que la pression va de 10⁻¹ à 10⁻⁵ bars.

5. Procédé selon l'une des revendications qui précèdent, caractérisé en ce que, durant le revêtement, le substrat est chauffé à une température de 400 à 1800°C.

6. Procédé selon l'une des revendications qui précèdent, caractérisé en ce que, après revêtement, le substrat est soumis à un traitement thermique complémentaire à des températures de 600 à 1800°C.

7. Procédé selon la revendication 6, caractérisé en ce que, lors du traitement complémentaire, le substrat est exposé à une atmosphère contenant de l'oxygène.

8. Procédé selon l'une des revendications qui précèdent, caractérisé en ce que le substrat est en métal ou en carbone ou en carbone et silicium ou en carbone, azote et silicium ou en azote et silicium.

9. Substrats revêtus par un procédé selon une ou plusieurs des revendications précédentes 1 à 8.
